# EUROPÄISCHE PATENTSCHRIFT

(11) **EP 0 928 516 B1**
(45) Veröffentlichungstag und Bekanntmachung des Hinweises auf die Patenterteilung: **04.10.2001**
(21) Anmeldenummer: 97934438.9
(22) Anmeldetag: 21.07.1997
(51) Int. Cl.: H03H 1/00

(54) **KOAXIALES DURCHFÜHRUNGSFILTER**
COAXIAL BUSHING FILTER
FILTRE COAXIAL DE TRAVERSEE

(30) Priorität: 27.09.1996 DE 19639880
(43) Veröffentlichungstag der Anmeldung: 14.07.1999
(73) Patentinhaber: EPCOS AG, 81541 München (DE)
(72) Erfinder: GÖTT, Achim, D-89520 Heidenheim (DE)
(74) Vertreter: Epping, Wilhelm, Dipl.-Ing.
(86) Internationale Anmeldenummer: DE9701530
(87) Internationale Veröffentlichungsnummer: WO9813931

(56) Entgegenhaltungen:
- EP-A- 0 691 737
- DE-A- 3 912 697

## Beschreibung

Die Erfindung betrifft ein koaxiales Durchführungsfilter in π-Schaltung mit zwei kapazitiven Quergliedern und einem ferromagnetischen Längsglied, bei dem die kapazitiven Glieder aus Wickelkondensatoren bestehen, die zusammen mit dem ferromagnetischen Längsglied auf einem Durchführungsleiter angeordnet sind, bei dem das ferromagnetische Längsglied innerhalb des Kondensatorwickels angeordnet ist, und bei dem die Wickelkondensatoren zumindest eine Stirnkontaktschicht aufweisen.

Die in π-Schaltung aufgebauten Filter bestehen aus zwei gleichen kapazitiven Quergliedern und einem ferromagnetischen Längsglied. Zur Erzielung ausreichend hoher Dämpfungswerte muß mindestens ein Belag konzentrisch angeordnet sein.

Ein Filter der eingangs genannten Art ist aus der EP 0 691 737 A1 bekannt. Hierbei sind die kapazitiven Querglieder in Form von zwei einzelnen, konzentrisch übereinander angeordneten Teilwickeln ausgeführt, die durch Trennlagen voneinander getrennt sind. Die Wickelstirnseiten werden je nach Aufbau durch mindestens drei Lötstellen mit dem Gehäuse und dem Durchführungsbolzen verbunden. Zur Realisierung der π-Schaltung ist zwischen den Kontaktstellen der Wickelstirnseiten das ferromagnetische Längsglied eingebaut. Jeweils eine der Wickelstirnseiten ist mit dem Gehäuse verbunden. Leitungsgebundene Störungen werden somit über das Gehäuse und eine Schirmwand der zu entstörenden Anlage abgeleitet.

Die Herstellung des bekannten Filters erfordert mehrere Anwickelvorgänge zum Einwickeln der Trennlagen und Wickeln der zweiten Teilkapazität. Außerdem müssen die Rückstände der durch Flammspritzen erzeugten Stirnkontaktschichten wieder von den Trennlagen entfernt werden.

Aufgabe der vorliegenden Erfindung ist es, ein koaxiales Durchführungsfilter der eingangs genannten Art anzugeben, das in einfacher und kostengünstiger Art hergestellt werden kann.

Diese Aufgabe wird erfindungsgemäß dadurch gelöst, daß die eine Elektrode der kapazitiven Querglieder durch jeweils eine Metallfolie gebildet ist, daß die gemeinsame Gegenelektrode durch eine Metallschicht gebildet ist, die durch ein Dielektrikum von den beiden Metallfolien getrennt ist, daß die Metallfolien mit definierten Abständen in Bezug auf das Dielektrikum angeordnet sind, und daß das ferromagnetische Längsglied an den Auflageflächen der Metallfolien und an den Stirnflächen mit einer leitfähigen Oberfläche versehen ist, die zur Kontaktierung der Teilkapazitäten dient.

Vorteilhafte Ausgestaltungen des Gegenstandes der Erfindung sind in den Unteransprüchen angeführt.

Die Erfindung wird im folgenden anhand von Ausführungsbeispielen erläutert.

In der dazugehörenden Zeichnung zeigen:
Fig.1 eine erste Ausführungsform und
Fig.2 eine weitere Ausführungsform eines koaxialen Durchführungsfilters.

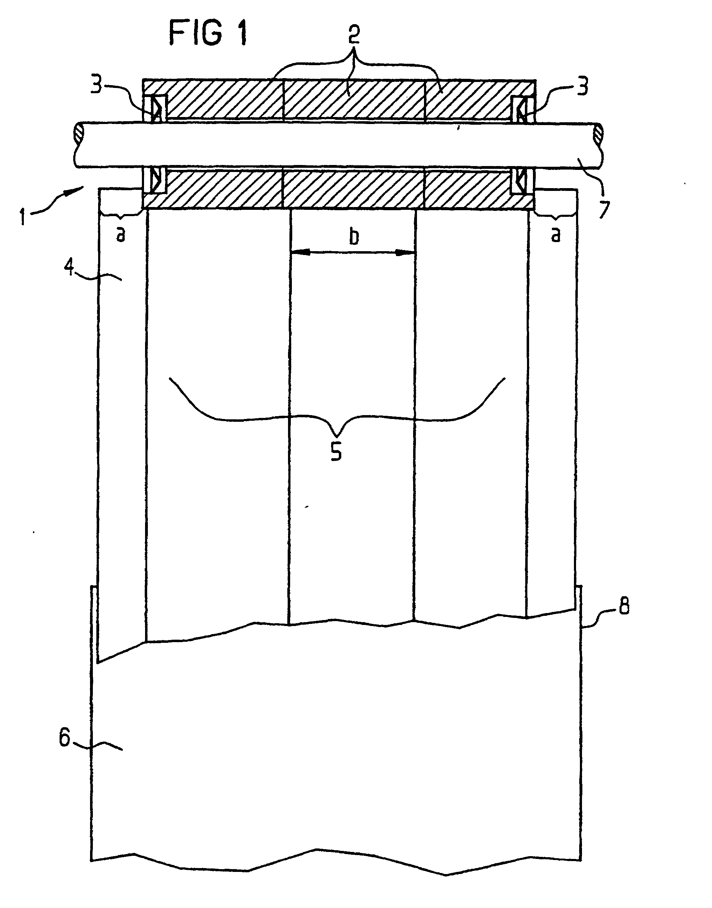

In Fig. 1 ist in teilweise aufgerollter Form ein koaxiales Durchführungsfilter 1 in π-Schaltung dargestellt. Der Kondensatorwickel mit den beiden Teikapazitäten ist direkt auf das ferromagnetische Längsglied 2 aufgewickelt. Das Längsglied 2 besteht bei dieser Ausführungsform aus einem beziehungsweise mehreren Rohrkernen. Der Wickel selbst besteht aus zwei Metallfolien 5, einer Dielektrikumsfolie 4 und einer metallbedampften Belagträgerfolie 6 (Gegenelektrode).

Die Metallfolien 5 werden mit definierten Abständen a, b zusammen mit der Dielektrikumsfolie 4 und dem Belagträger direkt auf das ferromagnetische Längsglied aufgewickelt. Die beiden Metallfolien 5 erzeugen dabei zusammen mit der Dielektrikumsfolie 4 und der Metallisierung auf der Belagträgerfolie 6 zwei Teilkapazitäten in einem Wickel.

Es ist auch möglich, die Metallisierung der Gegenelektrode direkt auf der Dielektrikumsfolie 4 anzubringen.

Weiterhin ist es möglich, statt der metallisierten Belagträgerfolie 6 ebenfalls eine Metallfolie zu verwenden.

Im ferromagnetischen Längsglied 2 ist der Durchführungsleiter 7 angeordnet, der durch leitfähige Verbindungselemente 3 mit dem Wickel verbunden ist.

Weitere elektrische Anschlußmöglichkeiten zwischen Durchführungsleiter 7 und Kondensatorwickel bestehen in einem mechanischen Formschluß oder einer Lötung.

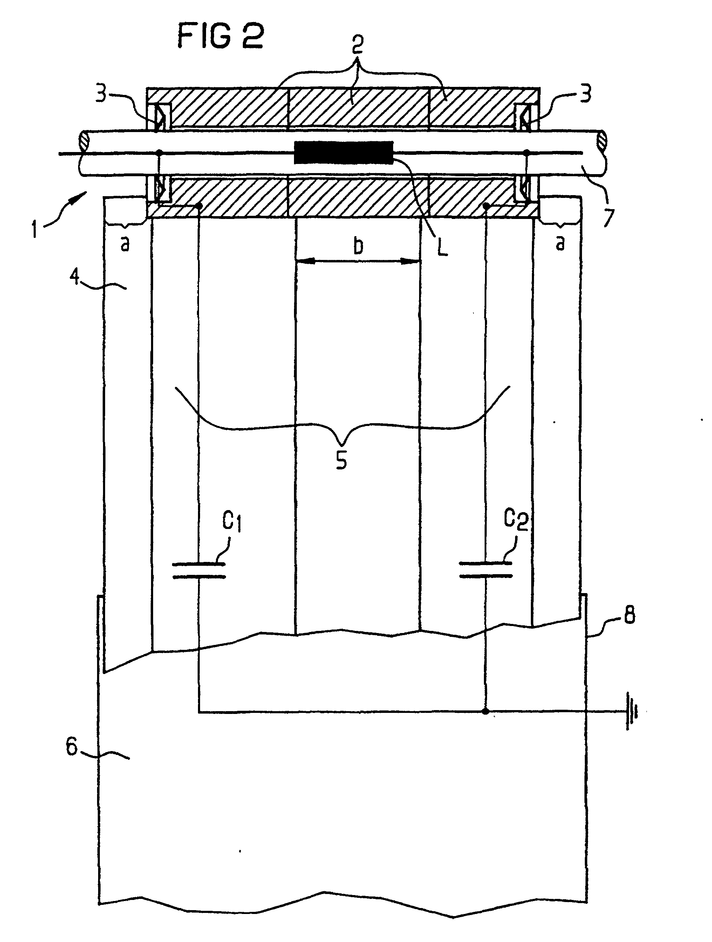

In der Fig. 2 ist dargestellt, daß die Kontaktierung der Teilkapazitäten C₁, C₂ über das ferromagnetische Längsglied 2 erfolgt. Das Längsglied 2 ist zu diesem Zweck an den Auflageflächen der Metallfolien 5 und seinen Stirnseiten mit einer leitfähigen Oberfläche versehen. Die restliche Oberfläche des Längsgliedes 2 wird isoliert.

Der Gemeinsame Pol der kapazitiven Querglieder wird durch die Metallisierung auf der Belagträgerfolie 6 gebildet, der nach dem üblichen Kontaktierungsverfahren, dem Flammspritzen, von beiden Seiten des Wickels zugänglich ist, und als Kontaktstelle zu einem Gehäuse benutzt werden kann.

Es ist bei dem geschilderten Aufbau auch möglich, nur eine Stirnseite des Wickels zu Kontaktieren, da sich die Belagträgerfolie 6 über die gesamte Wickelbreite erstreckt. Wegen des Überstandes a der Dielekrikumsfolie 4 über das ferromagnetische Längsglied 2 liegen beide Stirnseiten des Wickels auf gleichem Potential, so daß ein Reinigen der Mantelfläche des Wickels entfallen kann.

Durch das Wickeln direkt auf das ferromagnetische Längsglied 2 entfällt ein sonst zur Wickelherstellung benötigtes Kernrohr.

## Patentansprüche

1. Koaxiales Durchführungsfilter (1) in π-Schaltung mit zwei kapazitiven Quergliedern (C₁, C₂) und einem ferromagnetischen Längsglied (2), bei dem die kapazitiven Glieder (C₁, C₂) aus Wickelkondensatoren bestehen, die zusammen mit dem ferromagnetischen Längsglied (2) auf einem Durchführungsleiter (7) angeordnet sind, bei dem das ferromagnetische Längsglied (2) innerhalb des Kondensatorwickels angeordnet ist, und bei dem die Wickelkondensatoren zumindest eine Stirnkontaktschicht aufweisen,
**dadurch gekennzeichnet,**
**daß** die eine Elektrode der kapazitiven Querglieder (C₁, C₂) durch jeweils eine Metallfolie (5) gebildet ist, daß die gemeinsame Gegenelektrode durch eine Metallschicht gebildet ist, die durch ein Dielektrikum (4) von den beiden Metallfolien (5) getrennt ist, daß die Metallfolien (5) in einem Abstand (b) zueinander derart in Bezug auf das Dielektrikum (4) angeordnet sind, daß Randstreifen einer gewissen Breite (a) des Dielektrikums (4) nicht überdeckt sind, und daß das ferromagnetische Längsglied (2) an den Auflageflächen der Metallfolien (5) und an den Stirnflächen mit einer leitfähigen Oberfläche versehen ist, die zur Kontaktierung der Teilkapazitäten (C₁, C₂) dient.

2. Koaxiales Durchführungsfilter nach Anspruch 1,
**dadurch gekennzeichnet,**
**daß** die Gegenelektrode durch eine auf einer Kunststoffolie (6) angeordneten Metallisierung besteht.

3. Koaxiales Durchführungsfilter nach Anspruch 2,
**dadurch gekennzeichnet,**
**daß** die Kunststoffolie als Dielektrikum dient.

4. Koaxiales Durchführungsfilter nach Anspruch 1,
**dadurch gekennzeichnet,**
**daß** die Gegenelektrode durch eine Metallfolie gebildet ist.

5. Koaxiales Durchführungsfilter nach einem der Ansprüche 1 bis 4,
**dadurch gekennzeichnet,**
**daß** der Durchführungsleiter (7) über leitfähige Verbindungselemente (3) elektrisch mit dem Wickel verbunden ist.

6. Koaxiales Durchführungsfilter nach einem der Ansprüche 1 bis 4,
**dadurch gekennzeichnet,**
**daß** der Durchführungsleiter (7) mittels einer Lötung elektrisch mit dem Wickel verbunden ist.

7. Koaxiales Durchführungsfilter nach einem der Ansprüche 1 bis 4,
**dadurch gekennzeichnet,**
**daß** der Durchführungsleiter (7) mittels eines mechanischen Formschlusses elektrisch mit dem Wickel verbunden ist.

## Claims

1. Coaxial feedthrough filter (1) in π circuit with two capacitive parallel-path elements (C₁, C₂) and a ferromagnetic series-path element (2), in which the capacitive elements (C₁, C₂) comprise wound capacitors, which are arranged together with the ferromagnetic series-path element (2) on a feedthrough conductor (7), in which the ferromagnetic series-path element (2) is arranged inside the capacitor winding, and in which the wound capacitors have at least one end-face contact layer,
**characterized in that**,
one electrode of the capacitive parallel-path elements (C₁, C₂) is formed in each case by a metal foil (5), **in that** the common counter-electrode is formed by a metal layer which is separated from the two metal foils (5) by a dielectric (4), **in that** the metal foils (5) are arranged with respect to the dielectric (4) at a spacing (b) from one another in such a way that edge strips of a certain width (a) of the dielectric (4) are not covered, and **in that** the ferromagnetic series-path element (2) is provided at the supporting surface of the metal foils (5) and at the end faces with a conductive surface which serves to make contact with the component capacitors (C₁, C₂).

2. Coaxial feedthrough filter according to Claim 1,
**characterized in that**,
the counter electrode comprises a metallic coating arranged on a plastic film (6).

3. Coaxial feedthrough filter according to Claim 2,
**characterized in that**,
the plastic film serves as dielectric.

4. Coaxial feedthrough filter according to Claim 1,
**characterized in that**,
the counter electrode is formed by a metal foil.

5. Coaxial feedthrough filter according to one of Claims 1 to 4, **characterized in that**,
the feedthrough conductor (7) is electrically connected to the winding via conductive connecting elements (3).

6. Coaxial feedthrough filter according to one of Claims 1 to 4,
**characterized in that**,
the feedthrough conductor (7) is electrically connected to the winding by means of a soldered joint.

7. Coaxial feedthrough filter according to one of Claims 1 to 4,
**characterized in that**,
the feedthrough conductor (7) is electrically connected to the winding by means of a mechanical form fitting.

## Revendications

1. Filtre (1) coaxial de traversée en circuit π comprenant deux éléments (C₁, C₂) capacitifs transversaux et un élément (2) ferromagnétique longitudinal, dans lequel les éléments (C₁, C₂) capacitifs sont constitués de condensateurs bobinés qui ensemble avec l'élément (2) ferromagnétique longitudinal sont disposés sur une ligne (7) de traversée, dans lequel l'élément (2) ferromagnétique longitudinal est disposé à l'intérieur de la bobine du condensateur et dans lequel les condensateurs bobinés comportent au moins une couche frontale de contact,
**caractérisé**
**en ce que** l'une des électrodes des éléments (C₁, C₂) capacitif transversaux est formée respectivement par une feuille (5) métallique, en ce que la contre-électrode commune est formée par une couche métallique qui est séparée par un diélectrique (4) des deux feuilles (5) métalliques, en ce que les feuilles (5) métalliques sont disposées à une distance (b) l'une de l'autre par rapport au diélectrique (4) de façon que des bandes marginales d'une certaine largeur (a) du diélectrique (4) ne sont pas recouvertes, et en ce que l'élément (2) ferromagnétique longitudinal est muni sur les surfaces d'appui des feuilles (5) métalliques et sur les surfaces frontales d'une surface conductrice qui sert au contact des capacités (C₁, C₂) partielles.

2. Filtre coaxial de traversée suivant la revendication 1,
**caractérisé**
**en ce que** la contre-électrode est constituée par une métallisation disposée sur une feuille (6) de matière plastique.

3. Filtre coaxial de traversée suivant la revendication 2,
**caractérisé**
**en ce que** la feuille de matière plastique sert de diélectrique.

4. Filtre coaxial de traversée suivant la revendication 1,
**caractérisé**
**en ce que** la contre-électrode est formée par une feuille métallique.

5. Filtre coaxial de traversée suivant l'une des revendications 1 à 4,
**caractérisé**
**en ce que** la ligne (7) de traversée est reliée électriquement à la bobine par des éléments (3) conducteurs de liaison.

6. Filtre coaxial de traversée suivant l'une des revendications 1 à 4,
**caractérisé**
**en ce que** la ligne (7) de traversée est reliée électriquement à la bobine au moyen d'une brasure.

7. Filtre coaxial de traversée suivant l'une des revendications 1 à 4,
**caractérisé**
**en ce que** la ligne (7) de traversée est reliée électriquement à la bobine au moyen d'une complémentarité de forme mécanique.
